# EUROPEAN PATENT APPLICATION

(11) **EP 4 782 567 A1**
(43) Date of publication of application: **29.07.2026**
(21) Application number: 24874617.4
(22) Date of filing: 01.10.2024
(51) Int. Cl.: C23C 14/06, C23C 14/34, C30B 25/06, C30B 29/38, H01L 21/203

(54) **GALLIUM NITRIDE FILM, METHOD FOR PRODUCING SAME, LAMINATED SUBSTRATE, SEMICONDUCTOR ELEMENT, AND ELECTRONIC APPARATUS**

(30) Priority: 02.10.2023 JP 2023171488; 21.03.2024 JP 2024045754
(71) Applicant: Tosoh Corporation, Shunan-shi, Yamaguchi 746-8501 (JP)
(72) Inventor: UEOKA, Yoshihiro, Ayase-shi, Kanagawa 252-1123 (JP); KANO, Erisa, Ayase-shi, Kanagawa 252-1123 (JP); BANDO, Koo, Ayase-shi, Kanagawa 252-1123 (JP); MISAKI, Hidehiko, Ayase-shi, Kanagawa 252-1123 (JP); MESUDA, Masami, Ayase-shi, Kanagawa 252-1123 (JP)
(74) Representative: Novagraaf International SA
(86) International application number: PCT/JP2024/035161
(87) International publication number: WO 2025/075016

(57) **Abstract**

Provided are a gallium nitride film having high conductivity even if it is not heat-treated at a high temperature, a method for producing the same, a multi-layer substrate member, a semiconductor device, and an electronic apparatus; the gallium nitride film. The gallium nitride film is a gallium nitride film containing hydrogen. A content of the hydrogen may be 1.0 × 10¹⁹ atoms/cm³ or greater. The gallium nitride film may contain a dopant. A content of the dopant may be 1.0 × 10²⁰ atoms/cm³ or greater.

## Description

### Technical Field

The present disclosure relates to a gallium nitride film and a method for producing the same and also to a multi-layer substrate member, a semiconductor device, and an electronic apparatus.

### Background Art

Gallium nitride films are used in semiconductor devices, such as LEDs and transistors, and these gallium nitride films are required to have high conductivity in some cases.

Known examples of these gallium nitride films include a silicon-doped gallium nitride film formed on a substrate such as a wafer by a pulsed sputtering deposition method (PSD method) (see, for example, Non Patent Literature 1).

### Citation List

### Non Patent Literature

NPL 1: Applied Physics Express 14, 051011 (2021)

### Summary of Invention

### Technical Problem

However, the gallium nitride film described in Non Patent Literature 1 does not have sufficient conductivity in some cases. Note that even in the case of such a gallium nitride film, if the film is heat-treated at a high temperature, for example, by annealing, the film can have increased conductivity. In this case, however, in a semiconductor device including the gallium nitride film, not only the gallium nitride film but also electrodes, a substrate, and other structural elements end up being heat-treated at a high temperature, and, consequently, melting of the electrodes, warping of the substrate, and distortion of the entire semiconductor device are likely to occur.

An object of the present disclosure is to provide at least one of a gallium nitride film having high conductivity even if it is not heat-treated at a high temperature, a method for producing the same, a multi-layer substrate member, a semiconductor device, and an electronic apparatus.

### Solution to Problem

The content of the present invention is as set forth in the claims, and a summary of the present disclosure is as follows.
(1) A gallium nitride film containing hydrogen.
(2) The gallium nitride film according to (1), wherein a content of the hydrogen is 1.0 × 10¹⁹ atoms/cm³ or greater.
(3) The gallium nitride film according to (1) or (2), wherein the gallium nitride film has a surface roughness Ra of 5 nm or less.
(4) The gallium nitride film according to any one of (1) to (3), further containing a dopant.
(5) The gallium nitride film according to (4), wherein the dopant is an n-type dopant.
(6) The gallium nitride film according to (4) or (5), wherein a content of the dopant is 1.0 × 10²⁰ atoms/cm³ or greater.
(7) The gallium nitride film according to any one of (1) to (6), wherein the gallium nitride film has a film thickness of 1000 nm or less.
(8) A method for producing a gallium nitride film, the method comprising a deposition step that includes producing a hydrogen-containing gallium nitride film onto a substrate by sputtering a gallium nitride-containing sputtering target in a hydrogen-containing atmosphere.
(9) The method for producing a gallium nitride film according to (8), wherein the hydrogen-containing atmosphere is an atmosphere that contains hydrogen and at least one of argon and nitrogen.
(10) The method for producing a gallium nitride film according to (8) or (9), wherein the substrate has a temperature of 600°C or less.
(11) A multi-layer substrate member comprising the gallium nitride film according to any one of (1) to (7) and a substrate.
(12) A semiconductor device comprising the multi-layer substrate member according to (11).
(13) An electronic apparatus comprising the semiconductor device according to (12).

### Advantageous Effects of Invention

The present disclosure provides at least one of a gallium nitride film having high conductivity even if it is not heat-treated at a high temperature, a method for producing the same, a multi-layer substrate member, a semiconductor device, and an electronic apparatus.

### Brief Description of Drawings

[Fig. 1] Fig. 1 is a cross-sectional view illustrating an embodiment of a multi-layer substrate member of the present disclosure.
[Fig. 2] Fig. 2 is a schematic diagram illustrating an embodiment of an electronic apparatus of the present disclosure.

### Description of Embodiments

Embodiments of the present disclosure will be described in detail with reference to examples. Note that the present disclosure is not limited to the embodiments described below. In addition, the present disclosure encompasses any combination of features disclosed herein and any combination of numerical upper and lower limits disclosed herein.

### <Gallium Nitride Film>

First, an embodiment of a gallium nitride film of the present disclosure will be described.

The gallium nitride film of the present disclosure (hereinafter also referred to as a "GaN film") is a GaN film containing hydrogen and is preferably a sputtered GaN film containing hydrogen.

The GaN film, which contains hydrogen, has high conductivity even if it is not heat-treated at a high temperature. Accordingly, there is no need to heat-treat the GaN film at a high temperature to increase conductivity (i.e., reduce resistivity).

One possible reason that the hydrogen-containing GaN film has high conductivity even if it is not heat-treated at a high temperature is that defects present in the crystal lattice of the gallium nitride are filled by the hydrogen, and that, consequently, electrons are unlikely to be trapped in the defects.

Specifically, GaN films that have not been heat-treated at a high temperature have low crystallinity and have numerous defects in the crystal lattice. When a voltage is applied to such a GaN film, electrons are trapped in the defects, and the movement of the electrons is disturbed. It is considered that when a GaN film contains hydrogen, the hydrogen fills the defects, and as a result, when a voltage is applied to the GaN film, electrons are unlikely to be trapped in the defects; consequently, the conductivity of the GaN film is increased.

The GaN film of the present embodiment will be described in detail below.

### (Hydrogen)

The GaN film of the present embodiment contains hydrogen (H). "Containing hydrogen" refers to cases where hydrogen is detected in an amount of 0.5 × 10¹⁸ atoms/cm³ or greater by secondary ion mass spectrometry (SIMS), which will be described below.

The hydrogen content of the GaN film is not particularly limited. From the standpoint of further enhancing the conductivity of the GaN film, it is preferable that the hydrogen content be 1 × 10¹⁹ atoms/cm³ or greater, 1 × 10²⁰ atoms/cm³ or greater, 3 × 10²⁰ atoms/cm³ or greater, or 5 × 10²⁰ atoms/cm³ or greater.

The hydrogen content of the GaN film may be 1 × 10²² atoms/cm³ or less, 5 × 10²¹ atoms/cm³ or less, 2 × 10²¹ atoms/cm³ or less, or 1 × 10²¹ atoms/cm³ or less.

Regarding the hydrogen content of the GaN film, any combination of the above-mentioned upper and lower limits may be employed. Preferably, the hydrogen content is 1 × 10¹⁹ atoms/cm³ or greater and 1 × 10²² atoms/cm³ or less, 1 × 10²⁰ atoms/cm³ or greater and 5 × 10²¹ atoms/cm³ or less, 3 × 10²⁰ atoms/cm³ or greater and 5 × 10²¹ atoms/cm³ or less, or 5 × 10²⁰ atoms/cm³ or greater and 2 × 10²¹ atoms/cm³ or less.

The unit "atoms/cm³" for the hydrogen content means the number of atoms per cm³.

The hydrogen content of the GaN film is the lowest hydrogen content among hydrogen contents continuously measured by SIMS for an entire film thickness, from one surface to another surface on the opposite side of the GaN film, along a depth direction (film thickness direction). Regarding the SIMS measurement, greater numbers of measurement points are more preferable. The measurement is preferably performed at 5 or more points or 10 or more points and is more preferably performed at 20 or more points, 30 or more points, or 50 or more points, per 100 nm, for the entire film thickness. Specifically, the number of measurement points for the SIMS measurement may be 50 or more points and 200 or fewer points, for the entire film thickness.

### (Surface Roughness Ra)

The GaN film may have a surface roughness Ra that is not particularly limited. The surface roughness Ra may be, for example, 5 nm or less or may be greater than 5 nm.

Preferably, the Ra is 5 nm or less, 4 nm or less, 3 nm or less, 2 nm or less, or 1.5 nm or less. The Ra is one of the indices that indicate the smoothness of a surface of the GaN film. When the Ra is 5 nm or less, the smoothness of the surface of the GaN film is further improved, which makes it possible to inhibit the occurrence of the scattering of electrons and holes, which serve as charge carriers, and, thus, to further inhibit a decrease in the performance of semiconductor devices or electronic apparatuses.

The Ra may be 0 nm or greater, greater than 0 nm, 0.1 nm or greater, 0.5 nm or greater, or 1 nm or greater. The Ra of the GaN film of the present embodiment may be, for example, 0 nm or greater and 5 nm or less, greater than 0 nm and 5 nm or less, 0.1 nm or greater and 3 nm or less, 1 nm or greater and 3 nm or less, 1 nm or greater and 2 nm or less, or 1 nm or greater and 1.5 nm or less.

The surface roughness Ra represents an arithmetic mean roughness.

The surface roughness Ra can be measured with a common scanning probe microscope (e.g., SPM-9600 scanning probe microscope, manufactured by Shimadzu Corporation).

### (Dopant)

The GaN film may contain a dopant. When the GaN film contains a dopant, the conductivity of the GaN film can be further improved.

The dopant may be any dopant that is at least one of an n-type dopant and a p-type dopant. Preferably, the dopant is an n-type dopant.

The n-type dopant may be, for example, one or more selected from the group of silicon, germanium, and tin and is preferably silicon.

The p-type dopant may be, for example, one or more selected from the group of magnesium, zinc, and cadmium.

The GaN film may contain solely one dopant element or contain two or more dopant elements.

The GaN film may have a dopant content that is not particularly limited, provided that the content enables the GaN film to exhibit p-type or n-type characteristics. From the standpoint of further enhancing the conductivity of the GaN film, it is preferable that the dopant content be 1 × 10¹⁸ atoms/cm³ or greater, 1 × 10¹⁹ atoms/cm³ or greater, 1 × 10²⁰ atoms/cm³ or greater, or 1.2 × 10²⁰ atoms/cm³ or greater.

The dopant content of the GaN film may be 1 × 10²² atoms/cm³ or less, 5 × 10²¹ atoms/cm³ or less, 2 × 10²¹ atoms/cm³ or less, or 1 × 10²¹ atoms/cm³ or less.

Regarding the dopant content of the GaN film, any combination of the above-mentioned upper and lower limits may be employed. Preferably, the dopant content is 1 × 10¹⁸ atoms/cm³ or greater and 1 × 10²² atoms/cm³ or less, 1 × 10¹⁹ atoms/cm³ or greater and 5 × 10²¹ atoms/cm³ or less, 1 × 10²⁰ atoms/cm³ or greater and 2 × 10²¹ atoms/cm³ or less, or 1.2 × 10²⁰ atoms/cm³ or greater and 1 × 10²¹ atoms/cm³ or less.

The unit "atoms/cm³" for the dopant content means the number of atoms per cm³.

The dopant content of the GaN film is the lowest dopant content among dopant contents continuously measured by SIMS for the entire film thickness, from one surface to another surface on the opposite side of the GaN film, along a depth direction. Regarding the SIMS measurement, greater numbers of measurement points are more preferable. The measurement is preferably performed at 5 or more points or 10 or more points and more preferably at 20 or more points, 30 or more points, or 50 or more points, per 100 nm, for the entire film thickness. Specifically, the number of measurement points for the SIMS measurement may be 50 or more points and 200 or fewer points, for the entire film thickness.

### (Thickness)

The thickness of the GaN film is not particularly limited, provided that the thickness allows the use of the film as a semiconductor device or the like. The thickness may be 1000 nm or less, 500 nm or less, 200 nm or less, 150 nm or less, or 100 nm or less. Preferably, the thickness of the GaN film is 10 nm or greater, 20 nm or greater, 30 nm or greater, 40 nm or greater, or 50 nm or greater.

Regarding the thickness, any combination of the above-mentioned upper and lower limits may be employed. Preferably, the thickness is 10 nm or greater and 1000 nm or less, 20 nm or greater and 200 nm or less, 50 nm or greater and 200 nm or less, 30 nm or greater and 150 nm or less, or 50 nm or greater and 100 nm or less.

### (Resistivity)

The GaN film has high conductivity and may have a resistivity of 1 Ωcm or less, 5 × 10⁻¹ Ωcm or less, or 5 × 10⁻² Ωcm or less. While low resistivities are preferable, the resistivity may be 1 × 10⁻⁴ Ωcm or greater, 1 × 10⁻³ Ωcm or greater, or 1 × 10⁻² Ωcm or greater. The resistivity of the GaN of the present embodiment may be, for example, 1 × 10⁻⁴ Ωcm or greater and 1 Ωcm or less, 1 × 10⁻³ Ωcm or greater and 5 × 10⁻¹ Ωcm or less, or 1 × 10⁻² Ωcm or greater and 5 × 10⁻² Ωcm or less.

The resistivity is a value that can be measured with a common Hall effect measurement system (e.g., Model 8403 AC/DC Hall effect measurement system, manufactured by TOYO Corporation).

### <Multi-Layer Substrate Member>

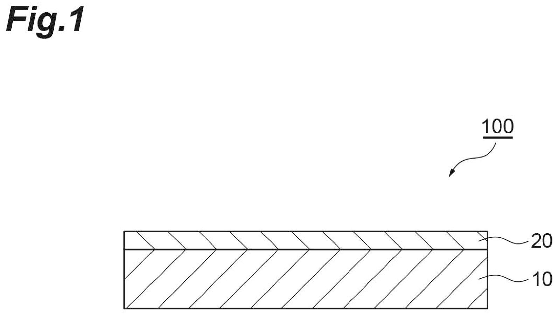

Next, an embodiment of a multi-layer substrate member of the present disclosure will be described with reference to Fig. 1.

As illustrated in Fig. 1, a multi-layer substrate member 100 includes a substrate 10 and a GaN film 20 and has a structure in which the GaN film 20 is directly disposed on the substrate 10. The multi-layer substrate member 100 can be regarded as a substrate member including a GaN film (a substrate with a film). The GaN film 20 is formed of the GaN film described above.

According to the multi-layer substrate member 100, no heat treatment at a high temperature for increasing conductivity needs to be performed on the GaN film 20, and, accordingly, no heat treatment at a high temperature needs to be performed also on the multi-layer substrate member 100 including the GaN film 20. That is, no heat treatment at a high temperature needs to be performed not only on the GaN film 20 but also on the substrate 10. Therefore, according to the multi-layer substrate member 100, the probability of the occurrence of warping of the substrate 10 and distortion of the entire multi-layer substrate member 100 can be reduced.

### (Substrate)

The substrate 10 is not particularly limited provided that it is a substrate (substrate member) that is used in semiconductor applications and the like. The substrate 10 may be, for example, a sapphire substrate, a silicon substrate, a gallium nitride substrate, a silicon carbide substrate, a glass substrate, a quartz substrate, a polyimide substrate, or a polyethylene terephthalate substrate and is preferably a sapphire substrate.

The substrate 10 may have a surface roughness Ra that is not particularly limited. Preferably, the surface roughness Ra is 10 nm or less, 1 nm or less, 0.5 nm or less, or 0.1 nm or less.

The surface roughness Ra of the substrate 10 may be 0 nm or greater or 0.01 nm or greater and may be 0 nm or greater and 10 nm or less, 0.01 nm or greater and 0.5 nm or less, or 0.01 nm or greater and 0.1 nm or less.

### <Method for Producing GaN Film>

A method for producing a GaN film of the present disclosure comprises a deposition step that includes producing a hydrogen-containing GaN film onto a substrate by sputtering a GaN-containing sputtering target in a hydrogen-containing atmosphere. The method for producing a GaN film of the present disclosure may further include a preparation step that is performed prior to the deposition step. Since the method for producing a GaN film of the present disclosure can provide a multi-layer substrate member, the method for producing a GaN film of the present disclosure can be referred to as a method for producing the multi-layer substrate member and can also be regarded as a method for depositing the GaN film or a method for forming the GaN film.

According to the method for producing a GaN film of the present disclosure, a GaN film having high conductivity even if it is not heat-treated at a high temperature can be produced. Furthermore, it is possible to produce a GaN film having high conductivity even if the substrate has a low temperature in the deposition step.

### (1) Preparation Step

Preferably, in the preparation step, a deposition apparatus is evacuated.

A vacuum level (ultimate vacuum level) in the deposition apparatus is not particularly limited provided that the vacuum level allows the deposition of the GaN film to proceed. Preferably, the vacuum level is 3 × 10⁻⁵ Pa or less, 1 × 10⁻⁵ Pa or less, or 5 × 10⁻⁶ Pa or less. When the vacuum level is 3 × 10⁻⁵ Pa or less, it is unlikely that residual gas is unintentionally incorporated as an impurity during deposition, and, consequently, the crystallinity of the GaN film is further improved. In the deposition apparatus, it is preferable that the deposition apparatus be baked to remove residual gas, before the deposition apparatus is evacuated. The vacuum level may be, for example, greater than 0 Pa, 1 × 10⁻⁸ Pa or greater, or 1 × 10⁻⁷ Pa or greater. Furthermore, the vacuum level may be greater than 0 Pa and 3 × 10⁻⁵ Pa or less, 1 × 10⁻⁸ Pa or greater and 1 × 10⁻⁵ Pa or less, or 1 × 10⁻⁷ Pa or greater and 5 × 10⁻⁶ Pa or less.

Preferably, the preparation step includes pre-treating the substrate. By performing a pre-treatment, an organic layer and irregularities can be removed from the surface of the substrate, and, therefore, epitaxial growth can be facilitated. Examples of methods for the pre-treatment include one or more selected from the group of reverse sputtering treatments, acid treatments, and UV treatments. From the standpoint of preventing impurities and the like from resettling after the treatment, it is preferable that the pre-treatment be a reverse sputtering treatment. The reverse sputtering treatment is a method for cleaning the surface of a substrate by bombarding the substrate with plasma atoms. Accordingly, the deposition can be accomplished in a state in which impurities and irregularities on the surface of the substrate are reduced. In order to prevent impurities resulting from reverse sputtering from settling in the deposition chamber, it is preferable to perform the reverse sputtering treatment in a chamber different from the deposition chamber. The gas species (sputtering gas) used for the reverse sputtering treatment may be, for example, one or more selected from the group of argon, nitrogen, and oxygen. Oxygen-containing sputtering gases are preferable because such gases facilitate the removal of carbon-based impurities from the surface of the substrate. Preferably, a content of the oxygen is 1% or greater and 10% or less based on the total pressure of all the constituent gases. Preferably, a treatment time for the reverse sputtering treatment is 30 seconds or more and 900 seconds or less, or 60 seconds or more and 300 seconds or less. In this case, the surface of the substrate can be made to have a surface roughness (Ra) suitable for the deposition of the GaN film, while impurities are removed from the surface of the substrate. The reverse sputtering treatment may be performed, for example, for 60 seconds under the conditions of 100 W and a sputtering gas including 29 sccm Ar (1 atm, 25°C) and 1 sccm O₂ (1 atm, 25°C).

Preferably, the preparation step includes holding the substrate for a certain period of time at the temperature at which the deposition is to be performed. In this case, the temperature of the substrate becomes uniform before it is subjected to the deposition, and, consequently, the crystallinity of the GaN film, which is the deposited product, is further improved. For example, it is preferable that the holding time be 1 minute or more, 5 minutes or more, or 10 minutes or more. On the other hand, from the standpoint of improving productivity, it is preferable that the holding time be 1 hour or less or 30 minutes or less. The holding time in the preparation step may be 1 minute or more and 1 hour or less or 10 minutes or more and 30 or less.

### (2) Deposition Step

### (Sputtering Target)

The GaN-containing sputtering target (hereinafter also simply referred to as a "target") may contain GaN, or the sputtering target may consist of GaN. In cases where a GaN film containing a dopant is to be deposited, the target may contain the dopant or consist of GaN that contains the dopant. In order to achieve the effect of the dopant, it is preferable that the amount of metal element impurities other than the dopant is small, and it is preferable that the purity calculated using the amount of metal element impurities excluding the dopant is 99.99% or more. The amount of metal element impurities in the target can be measured by GDMS.

The target may or may not contain hydrogen.

It is preferable that the target has an oxygen content of less than 3 atm% so that the crystallinity of the entire GaN film can be enhanced. More preferably, the oxygen content is 1 atm% or less.

It is preferable that the content of metal impurities in the target be low. Specifically, the content of metal impurities is preferably less than 0.1 mass% or less than 0.01 mass%.

An area of the target is not particularly limited and is preferably 18 cm² or greater or 100 cm² or greater. Larger areas of the target increase the stability of the discharge power and, consequently, enable the sputtering to be accomplished with a lower gas pressure and a lower discharge power density. In addition, uniformity of the film thickness and film quality is improved. The area of the target may be, for example, 10000 cm² or less, 5000 cm² or less, or 1000 cm² or less.

### (Sputtering)

The sputtering method may be any one or more methods selected from the group of DC sputtering methods, RF sputtering methods, AC sputtering methods, DC magnetron sputtering methods, RF magnetron sputtering methods, ECR sputtering methods, pulsed laser volume methods, and ion beam sputtering methods. Among these, at least one of a DC magnetron sputtering method and an RF magnetron sputtering method is preferable because these methods can perform deposition at a high speed and uniformly over a large area.

The gas pressure (deposition pressure) for sputtering is not particularly limited and may be, for example, 1.5 Pa or less, 1.0 Pa or less, or 0.6 Pa or less. Lower gas pressures for sputtering increase the likelihood that the particles emitted from the target reach the substrate while maintaining their high energy and, therefore, increase the likelihood that the particles are epitaxially realigned.

The gas pressure for sputtering may be, for example, 0 Pa or greater or 0.1 Pa or greater. Lower gas pressures for sputtering increase the likelihood that the particles (sputtered particles) emitted from the target reach the substrate while maintaining their high energy and, therefore, increase the likelihood that the particles are epitaxially realigned on the substrate. The gas pressure for sputtering may be, for example, 0 Pa or greater and 1.0 Pa or less, 0.1 Pa or greater and 1.0 Pa or less, 0 Pa or greater and 0.6 Pa or less, or 0.1 Pa or greater and 0.6 Pa or less.

### (Substrate)

The substrate to be used may be similar to the substrate 10.

Preferably, the deposition is performed with the substrate being heated. When the deposition is performed with the substrate heated, energy is imparted to the sputtered particles, which enables the GaN film to have a more stable crystalline state, thereby enabling the prevention of cracking of the substrate due to, for example, a difference in a coefficient of thermal expansion during the heat treatment at a high temperature.

Preferably, the temperature of the substrate during deposition is 600°C or less or 550°C or less.

The temperature of the substrate may be room temperature or greater, 100°C or greater, or 400°C or greater. When the temperature of the substrate is 100°C or greater, the crystallinity of the GaN film is likely to be increased, which reduces the amount of defects, and, consequently, the conductivity of the GaN film is likely to be increased even when the amount of hydrogen is small. Furthermore, when the temperature of the substrate is 400°C or greater, GaN particles, which are the sputtered particles, can be aligned in the GaN film such that good crystallinity is achieved.

Preferably, the temperature of the substrate is room temperature or greater and 600°C or less, 100°C or greater and 600°C or less, or 400°C or greater and 550°C or less.

### (Atmosphere)

The atmosphere for sputtering may be any atmosphere containing hydrogen (any hydrogen-containing atmosphere). The atmosphere may be made up of only hydrogen (H₂) or made up of a mixed gas of hydrogen and a different gas. Since the sputtering is performed in a hydrogen-containing atmosphere, the GaN film of the present embodiment can be deposited even in cases where a target not containing hydrogen is used. From the standpoint of enhancing safety, it is preferable that the hydrogen-containing atmosphere be made up of a mixed gas of hydrogen and a different gas.

Preferably, the different gas is an inert gas. Inert gases do not react with hydrogen and, therefore, do not form hydrogen compounds; accordingly, the introduction of hydrogen into the GaN film can be facilitated.

The inert gas may be at least one of argon and nitrogen. One of these may be used alone, or two or more kinds of them may be used in combination. Thus, a hydrogen-containing atmosphere that contains at least one of argon and nitrogen can be formed.

Preferably, the inert gas includes nitrogen. In this case, the GaN film that is produced can have a reduced number of nitrogen defects.

Preferably, the inert gas is made up of argon and nitrogen. In this case, a hydrogen-containing atmosphere that contains argon and nitrogen can be formed.

In another case, the inert gas is preferably made up of only nitrogen. In this case, a hydrogen-containing atmosphere that contains nitrogen can be formed, which enables the hydrogen-containing GaN film to be easily formed at a lower cost than with a hydrogen-containing atmosphere that contains argon.

The hydrogen-containing atmosphere that contains argon and nitrogen can be formed, for example, by separately supplying a nitrogen gas and a mixed gas containing hydrogen and argon. The atmosphere may be formed by separately supplying an argon gas and a mixed gas containing hydrogen and nitrogen or by supplying a mixed gas containing hydrogen, nitrogen, and argon. The hydrogen-containing atmosphere that contains nitrogen can be formed, for example, by supplying a mixed gas containing hydrogen and nitrogen or by separately supplying a hydrogen gas and a nitrogen gas.

In the case where the hydrogen-containing atmosphere is formed by separately supplying a nitrogen gas and a mixed gas containing hydrogen and argon, the content of the hydrogen in the mixed gas is not particularly limited provided that the content is higher than 0 vol.%; preferably, the content is 1 vol.% or greater, 2 vol.% or greater, or 3 vol.% or greater.

The content of the hydrogen in the mixed gas may be 99 vol.% or less, 80 vol.% or less, or 4 vol.% or less.

Preferably, the content of the hydrogen in the mixed gas is 1 vol.% or greater and 99 vol.% or less, 2 vol.% or greater and 80 vol.% or less, 2 vol.% or greater and 4 vol.% or less, or 3 vol.% or greater and 4 vol.% or less.

A flow rate ratio (partial pressure ratio) R of the mixed gas to the nitrogen gas is not particularly limited provided that a hydrogen-containing atmosphere can be formed. The flow rate ratio R may be 0.2 or greater and is preferably 0.6 or greater, 1 or greater, or 2 or greater. When the flow rate ratio R is 0.2 or greater, the conductivity of the resulting GaN film can be further increased.

The flow rate ratio R may be 5 or less, 4 or less, or 3.5 or less.

Preferably, the flow rate ratio R is 0.2 or greater and 5 or less, 0.6 or greater and 5 or less, 1 or greater and 4 or less, or 2 or greater and 3.5 or less.

Preferably, the discharge power density during power discharge is 0.01 W/cm² or greater and 5 W/cm² or less or 0.01 W/cm² or greater and 1 W/cm² or less. The discharge power density is calculated by dividing the power supplied during power discharge by the area of the target surface of the target. When the discharge power density during power discharge is 5 W/cm² or less, coarse single crystal particles are unlikely to be dislodged from the target by the power supplied to the target. When the discharge power density is 0.01 W/cm² or greater, the plasma is stabilized, which facilitates the power discharge and increases a deposition rate, and, consequently, productivity for the film is improved. In addition, the energy for the sputtering is increased, which improves adhesion ability for the deposition.

A deposition time may be appropriately adjusted in accordance with the thickness of the GaN film. Longer deposition times can increase the thickness of the GaN film. The deposition time may be, for example, 1 minute or more or 10 minutes or more, and 90 minutes or less, 60 minutes or less, or 30 minutes or less. Preferably, the deposition time is 1 minute or more and 90 minutes or less, 10 minutes or more and 60 minutes or less, or 10 minutes or more and 30 minutes or less.

### <Semiconductor Device>

A semiconductor device of the present disclosure includes a GaN film. The semiconductor device of the present disclosure may further include an electrode.

According to the semiconductor device of the present disclosure, no heat treatment at a high temperature for increasing conductivity needs to be performed on the GaN film, and, accordingly, no heat treatment at a high temperature needs to be performed also on the semiconductor device including the GaN film. That is, no heat treatment at a high temperature needs to be performed not only on the GaN film but also on the electrode, the substrate, and other constituent elements. Therefore, according to the semiconductor device, the probability of the occurrence of melting of the electrode, warping of the substrate, and distortion of the entire semiconductor device can be reduced.

The present disclosure is particularly useful in cases where the semiconductor device includes an electrode containing a low-melting-point metal, such as aluminum. This is because in cases where the electrode contains a low-melting-point metal, the heat treatment at a high temperature of the semiconductor device should not be performed in some cases so that the melting of the electrode can be avoided.

Examples of the semiconductor device include light emitting devices, such as blue light emitting diodes (LED) and blue laser diodes (LD), and power devices, such as diodes and transistors.

### <Electronic Apparatus>

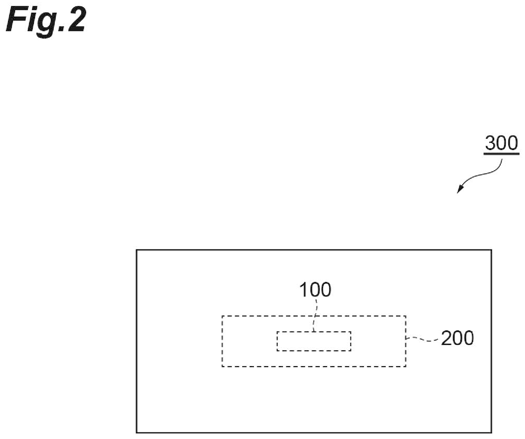

Next, an embodiment of an electronic apparatus of the present disclosure will be described with reference to Fig. 2.

As illustrated in Fig. 2, an electronic apparatus 300 includes a semiconductor device 200, and the semiconductor device 200 includes a multi-layer substrate member 100.

According to the electronic apparatus 300, the semiconductor device 200 can reduce the probability of the occurrence of melting of an electrode, warping of the substrate, and distortion of the entire semiconductor device 200, and, accordingly, a decrease in the performance of the electronic apparatus 300 can be inhibited.

Examples of the electronic apparatus 300 include mobile apparatuses, such as mobile phones, computers, such as servers, power converters, such as AC-DC converters, transportation apparatuses, such as automobiles, and aircraft, such as drones.

### EXAMPLES

The content of the present disclosure will now be described in more detail with reference to Examples. The present disclosure is not limited to the Examples described below.

### (Examples 1 to 6)

First, a substrate for deposition was prepared. The substrate was a sapphire substrate (off-angle: none, surface roughness Ra: 0.09 nm, diameter: 50.8 mm (2 inches)) manufactured by Shinkosha Co., Ltd. At this time, the surface of the sapphire substrate was a (0001) plane.

On the other hand, a Si-doped GaN sputtering target was prepared by mixing a silicon (Si) powder with a GaN powder and sintering the mixture.

Then, the substrate and the GaN sputtering target were placed in a magnetron sputtering apparatus.

A target-to-substrate distance was 150 mm, and, prior to deposition, the chamber interior was baked so that the ultimate vacuum level could be increased.

Next, at the start of sputtering, plasma was ignited using nitrogen gas with a shutter on the substrate side closed, and, accordingly, pre-sputtering was performed for 10 minutes under the same conditions as the deposition, to stabilize the discharge. A shutter-to-substrate distance was 5 mm. The shutter used had a size of 3 inches φ.

Then, GaN films were each produced by depositing the film onto the substrate as follows: the substrate was heated to a temperature of 500°C; a hydrogen-containing atmosphere that contained argon and nitrogen was formed by introducing a sputtering gas, which included a hydrogen-added Ar gas (mixed gas of hydrogen and argon) and a nitrogen gas, into the chamber; and the GaN sputtering target was sputtered under the deposition conditions shown in Table 1.

In Examples 1 to 6, the hydrogen-added Ar gas in the sputtering gas contained 3 vol.% hydrogen.

### (Example 7)

A GaN film was produced as in Example 1, except that a hydrogen-containing atmosphere that contained nitrogen was formed by using, as the sputtering gas introduced into the chamber, a gas that was made up of only a mixed gas of hydrogen and nitrogen (hydrogen-added nitrogen) and contained 3 vol.% hydrogen.

### (Comparative Example 1)

A GaN film was produced as in Example 1, except that the sputtering gas introduced into the chamber was a gas that was made up of only a nitrogen gas.

### <Properties>

The GaN films were evaluated as follows, and the results obtained are shown in Table 2.

### (Thickness of GaN Film)

A height difference between the deposited area and a non-deposited area was measured as a thickness (film thickness) of each of the GaN films, with a Dektak XT surface profiler (manufactured by Bruker).

### (Hydrogen Content)

The hydrogen content was continuously measured along a depth direction from the surface of the GaN film by SIMS. The lowest hydrogen content among the series of hydrogen contents measured over the entire film thickness, from the surface of the GaN film to an end on the substrate side (surface on the substrate side), was determined as the hydrogen content in the GaN film. The number of measurement points for the entire film thickness was as follows: 68 points in Example 1, 57 points in Example 2, 74 points in Example 3, 77 points in Example 4, 144 points in Example 5, 160 points in Example 6, 60 points in Example 7, and 168 points in Comparative Example 1.

### (Dopant Content)

The dopant (silicon) content was continuously measured along a depth direction from the surface of the GaN film by SIMS. The lowest dopant content among the series of dopant contents measured over the entire film thickness, from the surface of the GaN film to an end on the substrate side (surface on the substrate side), was determined as the dopant content in the GaN film. The number of measurement points for the entire film thickness was as follows: 68 points in Example 1, 57 points in Example 2, 74 points in Example 3, 77 points in Example 4, 144 points in Example 5, 160 points in Example 6, 60 points in Example 7, and 168 points in Comparative Example 1.

### <Conductivity>

A resistivity was used as an index of the conductivity of the GaN film.

The resistivity of the GaN film was measured with a Model 8403 AC/DC Hall effect measurement system (manufactured by TOYO Corporation).

### <Smoothness>

The surface roughness Ra was used as an index of the smoothness of the surface of the GaN film.

The Ra of the GaN film was measured with an SPM-9600 scanning probe microscope (manufactured by Shimadzu Corporation).

**[Table 1]**

| | Deposition Conditions | | | | | | | | | |
|---|---|---|---|---|---|---|---|---|---|---|
| | Method for Power Discharge | Ultimate Vacuum Level | Deposition Pressure | Sputtering Gas | | | Discharge Power | Discharge Power Density | Deposition Time | Substrate Temperature |
| | | | | Hydrogen-Added Ar | Hydrogen-Added Nitrogen | Nitrogen | | | | |
| | | 10⁻⁶Pa | Pa | sccm | sccm | sccm | w | W/cm² | min | °C |
| Example 1 | RF | 8.27 | 1 | 25 | 0 | 75 | 100 | 0.05 | 33 | 500 |
| Example 2 | RF | 1.05 | 1 | 37.5 | 0 | 62.5 | 100 | 0.05 | 25 | 500 |
| Example 3 | RF | 1.35 | 0.5 | 25 | 0 | 25 | 100 | 0.05 | 21 | 500 |
| Example 4 | RF | 1.76 | 1 | 50 | 0 | 50 | 100 | 0.05 | 34 | 500 |
| Example 5 | RF | 1.37 | 0.5 | 37.5 | 0 | 12.5 | 100 | 0.05 | 25 | 500 |
| Example 6 | RF | 3.1 | 0.5 | 37.5 | 0 | 12.5 | 100 | 0.05 | 40 | 500 |
| Example 7 | RF | 1.1 | 0.5 | 0 | 50 | 0 | 100 | 0.05 | 44 | 500 |
| Comparative Example 1 | RF | 0.91 | 0.5 | 0 | 0 | 50 | 100 | 0.05 | 120 | 500 |

**Table 2**

| | Properties of GaN Film | | | Conductivity | Smoothness |
|---|---|---|---|---|---|
| | Film Thickness | Hydrogen Content | Dopant Content | Resistivity | Ra |
| | nm | atoms/cm³ | atoms/cm³ | Ωcm | nm |
| Example 1 | 58 | 3.70E+20 | 1.42E+20 | 1.01.E-01 | 2.3 |
| Example 2 | 42 | 3.91E+20 | 1.40E+20 | 2.85.E-02 | 2.7 |
| Example 3 | 65 | 2.30E+20 | 1.35E+20 | 2.70.E-02 | 1.7 |
| Example 4 | 66 | 5.43E+20 | 1.30E+20 | 1.61.E-02 | 2.5 |
| Example 5 | 123 | 2.97E+20 | 1.33E+20 | 3.55.E-03 | 1.6 |
| Example 6 | 121 | 8.04+E20 | 1.72E+21 | 3.17.E-03 | 1.4 |
| Example 7 | 44 | 1.40E+21 | 1.22E+21 | 1.03.E-02 | 1.2 |
| Comparative Example 1 | 179 | 3.71E+18 | 1.52E+20 | 6.88.E+03 | 5.9 |

From the results shown in Table 2, the GaN films of Examples 1 to 7 had a maximum resistivity of 1.01×10⁻¹ (Ωcm), whereas the GaN film of Comparative Example 1 had a resistivity of 6.88 × 10³ (Ωcm).

Thus, it was confirmed that the GaN films of the present disclosure had low resistivity, that is, had high conductivity, even though they were not heat-treated at a high temperature.

The entire contents of the specifications, claims, drawings and abstracts of Japanese Patent Application No. 2023-171488, filed on October 2, 2023, and Japanese Patent Application No. 2024-045754, filed on March 21, 2024, are cited and incorporated herein as a disclosure of the specification of the present disclosure.

### Reference Signs List

10...substrate, 20...GaN film, 100...multi-layer substrate member, 200...semiconductor device, 300...electronic apparatus

## Claims

1. A gallium nitride film containing hydrogen.

2. The gallium nitride film according to claim 1, wherein a content of the hydrogen is 1.0 × 10¹⁹ atoms/cm³ or greater.

3. The gallium nitride film according to claim 1, wherein the gallium nitride film has a surface roughness Ra of 5 nm or less.

4. The gallium nitride film according to any one of claims 1 to 3, further containing a dopant.

5. The gallium nitride film according to claim 4, wherein the dopant is an n-type dopant.

6. The gallium nitride film according to claim 4 or 5, wherein a content of the dopant is 1.0 × 10²⁰ atoms/cm³ or greater.

7. The gallium nitride film according to any one of claims 1 to 6, wherein the gallium nitride film has a film thickness of 1000 nm or less.

8. A method for producing a gallium nitride film, the method comprising a deposition step that includes producing a hydrogen-containing gallium nitride film onto a substrate by sputtering a gallium nitride-containing sputtering target in a hydrogen-containing atmosphere.

9. The method for producing a gallium nitride film according to claim 8, wherein the hydrogen-containing atmosphere is an atmosphere that contains hydrogen and at least one of argon and nitrogen.

10. The method for producing a gallium nitride film according to claim 8 or 9, wherein the substrate has a temperature of 600°C or less.

11. A multi-layer substrate member comprising the gallium nitride film according to any one of claims 1 to 7 and a substrate.

12. A semiconductor device comprising the multi-layer substrate member according to claim 11.

13. An electronic apparatus comprising the semiconductor device according to claim 12.
